**Europäisches Patentamt**

**European Patent Office**

**Office européen des brevets**

(11) Veröffentlichungsnummer: **0 332 880**
**A2**

## (12) EUROPÄISCHE PATENTANMELDUNG

(21) Anmeldenummer: **89102829.2**

(22) Anmeldetag: **18.02.89**

(51) Int. Cl.⁴: **G03F 7/26 , H05K 3/10 , B22F 1/00**

(30) Priorität: **01.03.88 DE 3806515**

(43) Veröffentlichungstag der Anmeldung:
**20.09.89 Patentblatt 89/38**

(84) Benannte Vertragsstaaten:
**BE DE FR GB IT LU NL SE**

(71) Anmelder: **DU PONT DE NEMOURS (DEUTSCHLAND) GMBH**
**Du Pont Strasse 1**
**D-6380 Bad Homburg(DE)**

(72) Erfinder: **Dudek, Dietmer, Dr.**
**Philipp-Reis-Strasse 6**
**D-6370 Oberursel(DE)**
Erfinder: **Pfeiffer, Thomas, Dr.**
**25 Glenbarry Drive**
**Wilmington, DE19808(US)**

(54) **Verfahren zur Herstellung von Metalltonern.**

(57) Metalltoner, die zur Erzeugung von Leiterbahnzügen auf wärmebeständige Substrate aufgetragen werden, sollten frei fließen, sich beim Auftragen nicht entmischen und Leiterbahnen mit guter Haftung zum Substrat sowie hoher Leitfähigkeit ergeben.

Sie werden hergestellt, indem man Metallpulver mit Lösungen von Salzen weiterer Metalle benetzt, trocknet und einer Wärmebehandlung unterzieht.

Die Toner eignen sich zum Tonen klebriger Muster auf keramischen Substraten und zur Herstellung von Dickfilmpasten.

EP 0 332 880 A2

## Verfahren zur Herstellung von Metalltonern

Die Erfindung betrifft ein Verfahren zur Herstellung von Metalltonern, wie sie bei der Erzeugung von Leiterbahnenmustern für elektrische Schaltkreise auf wärmebeständigen Substraten verwendet werden.

Metallische Muster auf keramischen Substraten, z.B. Leiterbahnenmuster elektrischer Schaltkreise, werden seit längerer Zeit nach zwei verschiedenen Techniken erzeugt. In der sogenannten Dickfilmtechnik werden Pasten, die aus organischen Binde- und Lösemitteln bestehen, in denen das leitfähige Material und ggf. weitere Bestandteile dispergiert sind, in der Form des gewünschten Musters - beispielsweise durch Siebdruck - aufgetragen, getrocknet und eingebrannt. Diese Technik ist auf die Herstellung vergleichsweise dicker und breiter (mehr als 50 μm) Leiterbahnen beschränkt. Bei der Dünnfilmtechnik stellt man meist zunächst eine gleichmäßige dünne (um 1 μm) leitfähige Beschichtung her und formt das gewünschte Muster danach durch Photolithographie und Ätzen. Hierbei erreicht man zwar eine Musterfeinheit von weniger als einem Mikrometer. Der Aufwand an Gerät und Arbeitszeit ist jedoch beträchtlich.

In der letzten Zeit ist durch die kanadische Patentschrift 11 55 967 eine sogenannte "mid-film"-Technik bekannt geworden, durch die mit relativ geringem Aufwand Muster, die feiner als 50 μm sind, erzeugt werden können. Hierbei beschichtet man das Substrat mit einer lichtempfindlichen Zusammensetzung, auf deren Oberfläche man durch bildmäßige Belichtung ein Muster erzeugt, das sich in seiner Klebrigkeit vom Hintergrund unterscheidet. Danach bringt man die Oberfläche mit einem Pulver (sog. Toner) in Berührung, welches das leitfähige Material und die ggf. weiteren notwendigen Zusätze enthält. Beim nachfolgenden Brennen wird dann, ähnlich wie bei der Dickfilmtechnik, das organische Material verbrannt und das disperse leitfähige Material zu Leiterbahnen gesintert.

Die mittels der Dickfilmtechnik hergestellten leitfähigen Beschichtungen enthalten außer den meist metallischen leitfähigen Komponenten noch Verbindungen weiterer Metalle wie Glaspulver (Fritte) oder Metalloxide, z.B. Kupfer-, Wismut- oder Cadmiumoxid. Diese Verbindungen sollen die Haftung der fertigen Leiterbahnen am keramischen Substrat sicherstellen und ggf. den Sintervorgang des in der Paste teilchenförmig vorliegenden leitfähigen Materials steuern. Sie werden üblicherweise bei der Herstellung der Pasten mit eingearbeitet.

Nach der zitierten Patentschrift kann man die für die "mid-film"-Technik erforderlichen Toner gewinnen, indem man bekannte handelsübliche Dickfilmpasten erhitzt, bis die organischen Anteile verbrannt sind und den Rückstand zu einem Pulver der erforderlichen Feinheit mahlt. Dieses Verfahren hat jedoch mehrere Nachteile. So können Teile des organischen Bindemittels von schmelzenden Anteilen des Beschichtungsmaterials eingeschlossen und dadurch der Verbrennung entzogen werden. Diese Reste können später nach dem Einbrennen und Sintern Fehlstellen in den fertigen Leiterbahnen verursachen. Beim Mahlen des Erhitzungsrückstandes bilden sich aus den meist duktilen Metallteilchen des leitfähigen Anteils der Dickfilmpaste schuppenförmige Partikel. Da diese Partikel beim Tonen mit ihrer flachen Seite an der klebrigen Oberfläche haften und senkrecht zu dieser Oberfläche extrem dünn sind, läßt sich mit einem solchen Toner nur eine sehr geringe Belegungsdichte des leitfähigen Materials erreichen, so daß die Leitfähigkeit der fertigen Leiterbahnen unbefriedigend bleibt. Außerdem kann ein solcher Toner nicht frei fließen und hat daher nicht die Fähigkeit, alle Bereiche der klebrigen Oberfläche optimal auszufüllen. Weiterhin erscheint es zeitraubend und unwirtschaftlich, bei der Herstellung eines festen und im wesentlichen anorganischen Pulvers einen Umweg über Zubereitungen mit organischen Bestandteilen zu gehen, die dann doch wieder durch Verbrennen entfernt werden müssen.

Daher ist in der erwähnten kanadischen Patentschrift auch vorgeschlagen worden, ein Tonerpulver unmittelbar durch Mischen der sehr fein pulverisierten Bestandteile zuzubereiten und die gewünschte Tonerteilchengröße durch Zusatz eines organischen Bindemittels einzustellen. Dieses Verfahren führt jedoch ebensowenig wie das oben beschriebene zu Tonern, welche die Herstellung von Leiterbahnen mit befriedigender Qualität und Auflösung erlauben. Es zeigt sich nämlich, daß die einzelnen Teilchen der so hergestellten Toner in ihrer Zusammensetzung stark von der durchschnittlichen Zusammensetzung abweichen, weil die sehr verschiedenen Dichten und Adhäsionseigenschaften der Komponenten unvermeidlich zu Segregationserscheinungen führen. Dies gilt vor allem für solche Toner, die als Haftvermittler Metalloxide enthalten. Der Anteil der Metalloxide beträgt üblicherweise nur wenige Prozent, so daß schon die Bildung vergleichsweise weniger oxidreicher Agglomerate die Zusammensetzung des übrigen Toners stark verändert. Mit einem solchen Toner kann man selbstverständlich keine Leiterbahnen erzeugen, die an allen Stellen gleichermaßen auf dem Substrat haften. Außerdem ändert ein solcher Toner auch durch den Tonungsprozeß seine Zusammensetzung, weil die verschieden zusammengesetzten Teilchen an der klebrigen Oberfläche verschieden fest haften. Infolgedessen kann der beim Tonen eines Werkstücks anfallende Rest nicht zum Tonen weiterer Stücke benutzt, sondern muß entweder aufgearbeitet oder ganz verworfen werden. Schließlich beeinträchtigt das organische Bindemittel das freie Fließen des Toners, auf dessen Bedeutung bereits hingewiesen wurde.

Die Erfindung stellt sich die Aufgabe, ein Verfahren anzugeben, das die Herstellung von Metalltonern zur Erzeugung von Leiterbahnmustern auf wärmebeständigen Substraten durch Tonen klebriger Oberflächenmuster und Sintern der aufgetragenen Tonerteilchen ermöglicht, welche

- frei fließen, d.h. deren Teilchen sich weitgehend unabhängig voneinander bewegen können,
- die für die Steuerung der Haftung der Leiterbahnen auf dem Substrat und/oder des Sinterverhaltens geeigneten Verbindungen in möglichst homogener Verteilung enthalten,
- eine hohe Belegungsdichte der klebrigen Oberfläche und damit eine hohe Leitfähigkeit der resultierenden Leiterbahnzüge ermöglichen und die
- beim Tonungsprozeß ihre Zusammensetzung nicht ändern.

Diese Aufgabe wird durch ein Verfahren nach dem Anspruch 1 gelöst. Es wurde nämlich gefunden, daß man frei fließende Metalltoner für die Erzeugung von metallischen Mustern durch Tonen klebriger Oberflächenmuster auf keramischen Substraten und anschließendes Einbrennen, welche neben den für die Bildung der Leiterbahnen vorgesehenen ersten Metallen geeignete Verbindungen weiterer Metalle zur Vermittlung der Haftung der Leiterbahnen auf dem Substrat und/oder zur Steuerung des Sinterver haltens enthalten und deren Teilchen weitgehend einheitlich zusammengesetzt sind, erhält, wenn man

a) Pulver der für die Bildung der Leiterbahnmuster vorgesehenen ersten Metalle mit einer Lösung von Salzen der weiteren Metalle in einem Lösungsmittel gleichmäßig benetzt,

b) danach die benetzten Metallpulver bei einer Temperatur T1, die zum Verdampfen des Lösungsmittels ausreicht, trocknet und schließlich

c) die getrockneten Metallpulver auf eine Temperatur T2≥T1 erhitzt, bei der die geeigneten Verbindungen der weiteren Metalle gebildet werden, ohne daß die Korngrößenverteilung der Metallpulver irreversibel verändert wird.

Als erste Metalle für den Aufbau der Leiterbahnen kommen bevorzugt die Edelmetalle, insbesondere Gold, Silber, Platin, Palladium oder auch Legierungen dieser Metalle untereinander, in Betracht. In der Regel muß nämlich bei der Wärmebehandlung zur Erzeugung des Leiterbahnmusters aus dem getonten klebrigen Oberflächenmuster in einer ersten Stufe die klebrige, meist organische Substanz entfernt werden. Dies geschieht je nach Art der Substanz durch Verdampfen und/oder Luftoxidation. Die Bildung von Oxiden der ersten Metalle im Zuge der Wärmebehandlung ist jedoch unerwünscht, weil dadurch die Leitfähigkeit der Leiterbahnen vermindert würde. Man kann jedoch auch unedle Metalle, beispielsweise Kupfer, als erste Metalle verwenden, wenn sich die klebrige Substanz ihrer Art nach ohne Zutritt von Sauerstoff verflüchtigen läßt.

Die Korngröße der in dem erfindungsgemäßen Verfahren eingesetzten Pulver der ersten Metalle ist durch die angestrebte Feinheit der Leiterbahnen bestimmt. Sie liegt bevorzugt zwischen 0,1 und 10 µm. Bevorzugt werden auch Pulver, deren Teilchen annähernd kugelförmig sind. Eine enge Korngrößenverteilung ist günstig. Besonders bevorzugt wird eine zweigipflige Verteilung, bei der die feineren Teilchen so groß sind, daß sie die Lücken zwischen den dicht gepackten größeren Teilchen gerade ausfüllen.

Bekannte Verbindungen, welche geeignet sind, die Haftung der Leiterbahnen auf dem Substrat zu vermitteln und/oder das Sinterver halten der ersten Metalle zu steuern, sind Oxide und Resinate einer Reihe von weiteren Metallen. Im erfindungsgemäßen Verfahren ist jedoch der Begriff der "geeigneten Verbindungen" wesentlich umfassender zu verstehen. Es wurde nämlich überraschenderweise festgestellt, daß die gewünschte Haftvermittlung und Sinterungssteuerung auch eintritt, wenn die Temperatur T2 nicht hoch genug ist, um stöchiometrisch definierte Oxide zu erzeugen. Dies ist häufig auch gar nicht möglich, ohne daß die Korngrößenverteilung des Metallpulvers durch Sintern oder Schmelzen irreversibel verändert wird. Die chemische Charakterisierung der mit dem erfindungsgemäßen Verfahren erzeugten "geeigneten Verbindungen" ist derzeit nicht einheitlich möglich. Es wird vermutet, daß neben Oxiden auch basische Salze oder Hydroxide, ggf. in Gemischen oder komplizierteren Verbindungen vorliegen. Daher wird auf eine chemische Charakterisierung verzichtet und das als Toner geeignete Metallpulver durch das Herstellungsverfahren beschrieben.

Die Auswahl der weiteren Metalle richtet sich nach den speziellen Eigenschaften der verwendeten ersten Metalle sowie des Substrats. Aus der Literatur ist eine Reihe von Metallen bekannt, die in Form von Oxiden oder Resinaten in Dickfilmpasten zur Haftungsvermittlung und Sinterungssteuerung enthalten sind. Von diesen kommen bevorzugt Blei, Kupfer, Rhodium, Nickel, Aluminium, Cadmium, Eisen, Indium und Wismut allein oder in Mischungen in Betracht.

Als Salze der weiteren Metalle werden nach dem erfindungsgemäßen Verfahren vorzugsweise wasserlösliche Salze wie Chloride, Nitrate oder Acetate verwendet. Jedoch können auch andere Salze benutzt werden, wenn für sie ein geeignetes Lösungsmittel existiert.

Für die Herstellung der Lösung der Salze der weiteren Metalle wird vorzugsweise Wasser oder ein anderes polares Lösungsmittel, ggf. auch eine Mischung mehrerer derartiger Lösungsmittel, eingesetzt. Bei hydrolyseempfindlichen Salzen kann es notwendig sein, eine Säure oder Base zuzusetzen, um eine homogene Lösung zu erhalten.

Nachdem das Pulver des ersten Metalls mit der Lösung der Salze der weiteren Metalle gleichmäßig benetzt wurde, muß es bei einer Temperatur T1 getrocknet werden, die zweckmäßig annähernd der Siedetemperatur des Lösungsmittels entspricht. Bei rein wäßrigen Lösungen liegt T1 beispielsweise zwischen 80 und 120° C. Man kann jedoch auch die Methode der Gefriertrocknung anwenden. Beim Trocknen werden die Salze der weiteren Metalle meist in Form von Mikrokristallen auf den Teilchen des Metallpulvers niedergeschlagen. Um zu vermeiden, daß sich diese Mikrokristalle von der Oberfläche der Pulverteilchen ablösen, darf das Pulver in diesem Stadium nicht heftig bewegt werden.

Das getrocknete Pulver wird dann auf eine Temperatur T2 erhitzt, die mindestens gleich, vorzugsweise aber höher als T1 ist. Die im konkreten Fall angemessene Temperatur T2 kann leicht durch Versuche ermittelt werden. Sie darf nicht so hoch sein, daß die Korngrößenverteilung des Metallpulvers irreversibel, z.B. durch Sintern oder Schmelzen, verändert wird. Die an der Oberfläche der Pulverteilchen lose haftenden Salzmikrokristalle wandeln sich dabei in die oben erwähnten Verbindungen der weiteren Metalle um, die in der Regel wesentlich stärker an den Pulverteilchen haften. Wenn dabei die Metallteilchen untereinander verklebt werden, so ist dies unschädlich, solange die entstandenen Agglomerate durch geringe mechanische Einwirkung, beispielsweise durch Drücken mit einem Pinsel, wieder zerteilt werden können, ohne daß die Metallteilchen dabei verformt werden.

Wenn es für die Herstellung der Leiterbahnmuster erforderlich ist, daß das Pulver der ersten Metalle Verbindungen mehrerer weiterer Metalle enthält, so läßt sich das erfindungsgemäße Verfahren in verschiedenen Ausgestaltungen anwenden:

a) Man geht von einer Lösung aus, welche Salze aller weiteren Metalle in den erforderlichen Mengen enthält. Allerdings kann es mitunter schwierig sein, eine homogene Lösung von Salzen aller weiteren Metalle herzustellen.

b) Man stellt mehrere Pulver her, die hinsichtlich des ersten Metalls gleich sind, jedoch nur Verbindungen jeweils eines oder einiger der weiteren Metalle enthalten. Diese Pulver werden zur Verwendung als Toner im erforderlichen Verhältnis gemischt. Ein solcher Toner ist jedoch nicht homogen, da er Teilchen verschiedener Zusammensetzung enthält.

c) Man führt das Verfahren mit ein und demselben Pulver des ersten Metalls mehrfach durch, wobei die Lösung bei jedem Mal ein anderes der weiteren Metalle enthält. Diese Methode wird im allgemeinen bevorzugt. Es muß jedoch sichergestellt werden, daß eine in einem Zyklus erzeugte Verbindung eines weiteren Metalls in den bei den folgenden Zyklen verwendeten Lösungsmitteln unlöslich ist.

Es wurde weiterhin gefunden, daß die Menge der als Haftvermittler und zur Sinterungssteuerung geeigneten Verbindungen der weiteren Metalle gegenüber dem Stand der Technik beträchtlich vermindert werden kann. So kann die molare Gesamtmenge der ersten Metalle in der Rezeptur das Zwanzigfache oder mehr der molaren Gesamtmenge aller weiteren Metalle betragen. Man erhält auch dann noch hervorragende Ergebnisse, wenn dieses Verhältnis mehr als das Hundertfache beträgt.

Für die Erzeugung der klebrigen Oberflächenmuster können bekannte Verfahren angewandt werden. Beispielsweise kann ein Klebstoff im Siebdruckverfahren auf das Substrat aufgetragen werden. Wegen des höheren Auflösungsvermögens und der daraus resultierenden wesentlich höheren erreichbaren Feinheit der Leiterbahnen wird jedoch die photochemische Erzeugung der klebrigen Muster bevorzugt. Geeignete Verfahren sind in den deutschen Patentschriften 12 10 321, 19 04 059, 19 44 311, 27 28 209, 28 15 894, 30 23 247, 34 29 615 und anderen beschrieben.

Als wärmebeständige Substrate finden, dem derzeitigen Stand der Technik entsprechend, hauptsächlich Formkörper aus Aluminiumoxid Verwendung. Die nach dem erfindungsgemäßen Verfahren hergestellten Metalltoner lassen sich jedoch auch zur Herstellung von Leiterbahnen auf anderen Substratmaterialien, beispielsweise Berylliumoxid, Siliciumdioxid, Aluminiumnitrid oder Emailschichten auf metallischen Trägern, verwenden.

Die erfindungsgemäßen Metalltoner enthalten die als Haftungsvermittler und zur Sinterungssteuerung geeigneten Verbindungen der weiteren Metalle in optimal gleichmäßiger Verteilung. Daher kann der Anteil dieser Verbindungen im Metalltoner geringer sein als es nach dem Stand der Technik erforderlich wäre, um an allen Stellen des Leiterbahnmusters ausreichende Wirkung zu entfalten. Dies wirkt günstig auf die Leitfähigkeit der fertigen Leiterbahnen.

Die mit den erfindungsgemäßen Tonern hergestellten Leiterbahnzüge haben einen sehr gleichmäßigen Querschnitt, haften ausgezeichnet am Substrat und haben eine hohe Leitfähigkeit. Sie haften auch gleichmäßiger am Substrat, was sich in einer geringeren Streuung der Ergebnisse von Adhäsionstests zu erkennen gibt. Dadurch wird die Ausschußrate, d.h. der Anteil von Werkstücken mit unzureichender Haftung, wesentlich vermindert.

Beim Tonen der klebrigen Oberflächenmuster mit den erfindungsgemäßen Tonern kann eine hohe Belegungsdichte mit Metall erzielt werden, da die Toner gegenüber dem Stand der Technik nur sehr wenig Fremdsubstanz enthalten. Es tritt auch keine Entmischung ein, so daß ein und dieselbe Tonermenge wiederholt zum Tonen verwendet werden kann, ohne daß die nacheinander hergestellten Werkstücke sich in ihren Eigenschaften unterscheiden.

Die nach dem erfindungsgemäßen Verfahren hergestellten Metalltoner werden in der Hauptsache unmittelbar zum Tonen klebriger Oberflächenmuster zur Erzeugung elektrischer Schaltkreise verwendet. Sie können aber auch in bekannter Weise als leitfähige Komponente in Dickfilmpasten eingearbeitet werden, aus denen beispielsweise mittels Siebdruck Muster auf wärmebeständigen Substraten gebildet werden, welche durch Wärmebehandlung in Leiterbahnen übergehen. Bei der Herstellung solcher Pasten braucht man dann Verbindungen zur Haftungsvermittlung und Sinterungssteuerung nicht mehr gesondert zuzugeben.

Es liegt auf der Hand, daß die erfindungsgemäßen Metalltoner auch für andere Verfahren verwendet werden können, bei denen es auf die Erzeugung von ggf. gemusterten Metallschichten auf wärmebeständigen Substraten ankommt, beispielsweise bei der Dekoration keramischer Erzeugnisse.

Die folgenden Ausführungsbeispiele sollen die Erfindung näher erläutern.

Beispiel 1 (Stand der Technik)

Herstellung des Toners:

62,5 mg Wismutoxid, 31,3 mg Cadmiumoxid, 6,3 mg Kupfer-(I)-oxid und 8,6 mg Rhodium-(III)-oxid wurden fein gepulvert, in 3 ml Wasser aufgeschlämmt und dabei sorgfältig durchmischt. In diese Suspension wurden 5 g Goldpulver mit einer mittleren Korngröße von 2 $\mu$m portionsweise eingerührt. Die Mischung wurde vorsichtig getrocknet, 30 min lang auf 500° C erhitzt und nach dem Abkühlen durch ein Sieb mit 30 $\mu$m Maschenweite gesiebt.

Prüfung des Toners:

5 x 5 cm große Plättchen aus gesintertem Aluminiumoxid wurden mit einer Lösung von
3,25 g Dimethylester von 2,6-Dimethyl-4-(2'-nitrophenyl)-1,4-dihydropyridin-3,5-dicarbonsäure und
3,25 g Diethylester von 2,6-Dimethyl-4-(2'-nitrophenyl)-1,4-dihydropyridin-3,5-dicarbonsäure in
100 ml Methylethylketon
beschichtet. Nach dem Trocknen betrug die Schichtdicke 1,5 - 2 $\mu$m. Auf diese Schicht wurde mit einer Quecksilberdampflampe ein Muster aufbelichtet, welches Leiterbahnen von 25 $\mu$m Breite zur Prüfung des Widerstands und quadratische Flächen von 2 x 2 mm zur Bondprüfung enthielt. Die belichtete Schicht wurde mit dem Toner nach dem Verfahren der Patentanmeldung P 37 36 391.3 getont. Danach wurden die Probeplättchen 10 min bei 900° C gebrannt.

Zunächst wurden einige Probeplättchen hergestellt und geprüft. Dann wurde mit der vorgelegten Tonermenge so lange weitergearbeitet, bis 20% davon verbraucht waren. Nun wurden wiederum einige Probeplättchen hergestellt und geprüft. Auf diese Weise sollte festgestellt werden, wie sich der Toner durch den Tonungsvorgang verändert.

Durch Wägung einzelner Probeplättchen vor und nach dem Tonen der belichteten lichtempfindlichen Schicht wurde festgestellt, wieviel Toner von dem klebrigen Muster aufgenommen worden war.

Die Adhäsion der Goldschicht auf dem Substrat wurde bestimmt, indem 37,5 $\mu$m starke Golddrähte auf die 2 x 2 mm großen Flächen aufgebondet wurden und die zum Abreißen nötige Kraft bestimmt wurde. Dieser Versuch wurde 100 mal wiederholt. Registriert wurde die Anzahl der Versuche, bei denen die Kraft beim Abriß kleiner als 10 cN war. Die mikroskopische Untersuchung der Leiterbahnen zeigte, daß sie zwar keine Unterbrechungen aufwiesen, ihre Ränder jedoch stark ausgefranst mit Einkerbungen bis zu 10 $\mu$m Tiefe erschienen.

Die weiteren Prüfergebnisse sind in der Tabelle 1 aufgeführt.

Beispiel 2 (Erfindung)

5 g Goldpulver (wie in Beispiel 1) wurden in eine Lösung von 104 mg Wismut-(III)-acetat in 5 ml Eisessig eingetragen. Nach vorsichtigem Trocknen wurde die Mischung 30 min lang auf 400° C erhitzt. Nach dem Abkühlen wurde das Pulver durch ein Sieb mit 30 µm Maschenweite gesiebt und in eine Lösung von 56,6 mg Cadmiumacetat, 16,2 mg Kupfer-(II)-acetat und 19,0 mg Rhodium-(III)-acetat in 5 ml Wasser eingetragen. Diese Mischung wurde wiederum getrocknet, 30 min auf 400° C erhitzt und gesiebt.

Mit dem fertigen Toner wurden Testmuster auf Probeplättchen aus gesintertem Aluminiumoxid hergestellt, wie im Beispiel 1 beschrieben. Die mikroskopische Untersuchung der Probe zeigte Leiterbahnen mit nahezu glatten Rändern.

Alle anderen Prüfergebnisse sind in Tabelle 1 aufgeführt.

Tabelle 1

| Toner nach | Beispiel 1 | Beispiel 2 |
|---|---|---|
| Vom klebrigen Muster aufgenommener Toner (mg/cm$^2$) | 3,8 | 5,7 |
| Spezifischer Widerstand der Leiterbahn (µΩcm) | 4,8 | 4,0 |
| Abrisse < 10 cN, frischer Toner | 27% | 0% |
| Abrisse < 10 cN, zu 20% verbrauchter Toner | 99% | 1% |

**Ansprüche**

1. Verfahren zur Herstellung von Metalltonern für die Erzeugung von Leiterbahnmustern auf wärmebeständigen Substraten durch Auftragen der Toner auf das Substrat und anschließendes Verdichten durch Wärmebehandlung, welche neben den für die Bildung der Leiterbahnen vorgesehenen ersten Metallen geeignete Verbindungen weiterer Metalle zur Vermittlung der Haftung der Leiterbahnen auf dem Substrat und/oder zur Steuerung des Sinterverhaltens der ersten Metalle enthalten,
dadurch gekennzeichnet, daß man
a) Pulver der für die Bildung der Leiterbahnmuster vorgesehenen ersten Metalle mit einer Lösung von Salzen der weiteren Metalle in einem Lösungsmittel gleichmäßig benetzt,
b) danach die benetzten Metallpulver bei einer Temperatur T1, die zum Verdampfen des Lösungsmittels ausreicht, trocknet und schließlich
c) die getrockneten Metallpulver auf eine Temperatur T2 ≥ T1 erhitzt, bei der die geeigneten Verbindungen der weiteren Metalle gebildet werden, ohne daß die Korngrößenverteilung der Metallpulver irreversibel verändert wird.

2. Verfahren nach Anspruch 1,
dadurch gekennzeichnet, daß
die Pulver der ersten Metalle eine Teilchengröße von 0,1 bis 10 µm aufweisen.

3. Verfahren nach Anspruch 1 und 2,
dadurch gekennzeichnet, daß
als erste Metalle Gold, Silber, Palladium, Platin oder Legierungen zweier oder mehrerer dieser Metalle verwendet werden.

4. Verfahren nach Anspruch 1 und 3,
dadurch gekennzeichnet, daß
die Teilchen der Metallpulver annähernd kugelförmig sind.

5. Verfahren nach Anspruch 1 bis 4,
dadurch gekennzeichnet, daß
als geeignete Verbindungen weiterer Metalle Verbindungen des Kupfers, Bleis, Rhodiums, Nickels, Aluminiums, Cadmiums, Eisens, Indiums und/oder Wismuts verwendet werden.

6. Verfahren nach Anspruch 1 bis 5,
dadurch gekennzeichnet, daß
als Salze der weiteren Metalle wasserlösliche Salze verwendet werden.

6

7. Verfahren nach Anspruch 1 bis 6,
dadurch gekennzeichnet, daß
als wasserlösliche Salze Acetate, Nitrate und/oder Chloride des Kupfers, Bleis, Rhodiums, Nickels, Aluminiums, Cadmiums, Eisens, Indiums und/oder Wismuts verwendet werden.

8. Verfahren nach Anspruch 1 bis 7,
dadurch gekennzeichnet, daß
das Lösungsmittel aus Wasser und/oder anderen polaren Flüssigkeiten besteht und ggf. eine Säure oder Lauge enthält.

9. Verfahren nach Anspruch 1 bis 8,
dadurch gekennzeichnet, daß
wenn der Toner mehrere geeignete Verbindungen weiterer Metalle enthalten soll, diese geeigneten Verbindungen in mehreren getrennten, aufeinanderfolgenden Arbeitsgängen jeweils nach einem Verfahren nach einem der Ansprüche 1 bis 9 eingebracht werden.

10. Verfahren nach Anspruch 1 bis 9,
dadurch gekennzeichnet, daß
das wärmebeständige Substrat aus Aluminiumoxid, Berylliumoxid, Siliciumdioxid, Aluminiumnitrid oder emailliertem Metall besteht.

11. Verfahren nach Anspruch 1 bis 10,
dadurch gekennzeichnet, daß
das molare Verhältnis der Gesamtmenge aller ersten Metalle zur Gesamtmenge aller in Form von Salzen eingesetzten weiteren Metalle mindestens 20 beträgt.

12. Tonerpulver für die Herstellung von Leiterbahnenmustern auf wärmebeständigen Substraten durch Tonen klebriger Oberflächenmuster und anschließendes Verdichten durch Wärmebehandlung, welches neben den für die Bildung der Leiterbahnen vorgesehenen ersten Metallen geeignete Verbindungen weiterer Metalle zur Vermittlung der Haftung der Leiterbahnen auf dem Substrat und/oder zur Steuerung des Sinterverhaltens der ersten Metalle enthält,
dadurch gekennzeichnet, daß
es mindestens einen Metalltoner enthält, welcher gemäß einem Verfahren nach einem der Ansprüche 1 bis 11 hergestellt wurde.

13. Paste zur Herstellung von Leiterbahnmustern auf wärmebeständigen Substraten durch musterartiges Auftragen der Paste und nachfolgende Wärmebehandlung, enthaltend mindestens ein Pulver eines ersten Metalls, ein organisches Bindemittel, ein Lösungsmittel und geeignete Verbindungen weiterer Metalle zur Vermittlung der Haftung der Leiterbahnen auf dem Substrat und/oder zur Steuerung des Sinterverhaltens der ersten Metalle,
dadurch gekennzeichnet, daß
sie mindestens einen Metalltoner enthält, welcher gemäß einem Verfahren nach einem der Ansprüche 1 bis 11 hergestellt wurde.